Europäisches Patentamt

European Patent Office

Office européen des brevets

(19)

(11) Numéro de publication: **0 083 538**
**B1**

(12) **FASCICULE DE BREVET EUROPEEN**

(45) Date de publication du fascicule du brevet: 03.06.87

(51) Int. Cl.⁴: **H 05 K 7/20**

(21) Numéro de dépôt: 82402374.1

(22) Date de dépôt: 23.12.82

(54) **Procédé de fabrication d'un dispositif de refroidissement pour carte de circuit imprimé, utilisation de ce procédé.**

(30) Priorité: 31.12.81 FR 8124588

(43) Date de publication de la demande:
13.07.83 Bulletin 83/28

(45) Mention de la délivrance du brevet:
03.06.87 Bulletin 87/23

(84) Etats contractants désignés:
DE GB IT NL

(56) Documents cités:
WO-A-81/03734
DE-A-1 439 308
FR-A-2 374 519
US-A-2 815 472

IRE TRANSACTIONS ON COMPONENT PARTS,
vol. 2, no. 3, septembre 1956, pages 38-44, New
York, US; M. Mark et al.: "Design and
performance of air-cooled chassis for
electronic equipment"

(73) Titulaire: THOMSON-CSF
173, Boulevard Haussmann
F-75379 Paris Cedex 08 (FR)

(72) Inventeur: Berland, Robert THOMSON-CSF SCPI
173, bld Haussmann
F-75379 Paris Cedex 08 (FR)
Inventeur: Dumont, Bernard THOMSON-CSF
SCPI
173, bld Haussmann
F-75379 Paris Cedex 08 (FR)

Courier Press, Leamington Spa, England.

## Description

La présente invention concern un procédé de fabrication d'un dispositif de refroidissement pour carte de circuit imprimé et son utilisation à la fabrication d'une carte du circuit imprimée munie d'un tel dispositif.

Deux principes sont actuellement utilisés pour refroidir une carte de circuit imprimé.

— le refroidissment par convection dans l'air:
Cette solution présente de grands risques de pollution des composants et du circuit imprimé lui-même.
— Le refroidissement par conduction dans un drain thermique réalisé dans l'épaisseur de la carte de circuit imprimé. Ce système est particulièrement lourd et difficilement utilisable dans un matériel aéroporté.

Un dispositif connu est décrit dans la demande de brevet PCT WO—A—81/03 734. Il montre (figure 11) un composant placé dans un support (socket 110), lui-même monté sur une carte de circuit imprimé (10) placée sur une structure de refroidissement dans laquelle un fluide peut circuler.

L'article IRE Transactions on component parts, volume 2, numéro 3, septembre 1956, pages 38—44, New York, US., M. Mark et al.: "Design and performance of Air-Cooled Chassis for Electronic Equipment" décrit une structure de refroidissement voisine de la précédente.

La demande de brevet allemande 1 439 308 décrit encore une structure de refroidissement voisine, portant directement des composants munis de pattes de connexion. Les composants sont connectés à une carte de circuit imprimé par des pattes, passant dans la structure de refroidissement, au milieu fluide qui y circule.

Par ailleurs, il n'est donné dans aucun de ces documents de procédé de fabrication particulier.

Un but de la présente invention est de remédier aux inconvénients et limitations précités en permettant l'obtention d'un dispositif de refroidissement pour carte de circuit imprimé assurant une excellente dissipation thermique, notamment utilisable dans du matériel aéroporté, c'est-à-dire qui ne pénalise pas le poids du matériel et qui permette un gain de volume.

Un autre but de la présente invention est d'être utilisable non seulement pour des cartes sur lesquelles des composants sont implantés à plat mais également pour des cartes sur lesquelles sont implantés des composants intégrés en boîtiers dits "Dual-in-line" ou DIL.

L'invention a donc pour objet un procédé de fabrication d'un dispositif de refroidissement pour carte de circuit imprimé tel que défini par la revendication 1.

La présente invention sera mieux comprise à la lecture de la description détaillé faite ci-après avec référence aux dessins ci-annexés qui représentent:

— figure 1, une vue en coupe d'un mode de réalisation du dispositif selon l'invention;
— figure 2, une vue en coupe d'un autre mode de réalisation du dispositif selon l'invention;
— figure 3, une vue du dessus du dispositif de la figure 2;
— figure 4a à 4d, un procédé de fabrication du dispositif de la figure 1; et
— figure 5a à 5d, un procédé de fabrication du dispositif des figures 2 et 3.

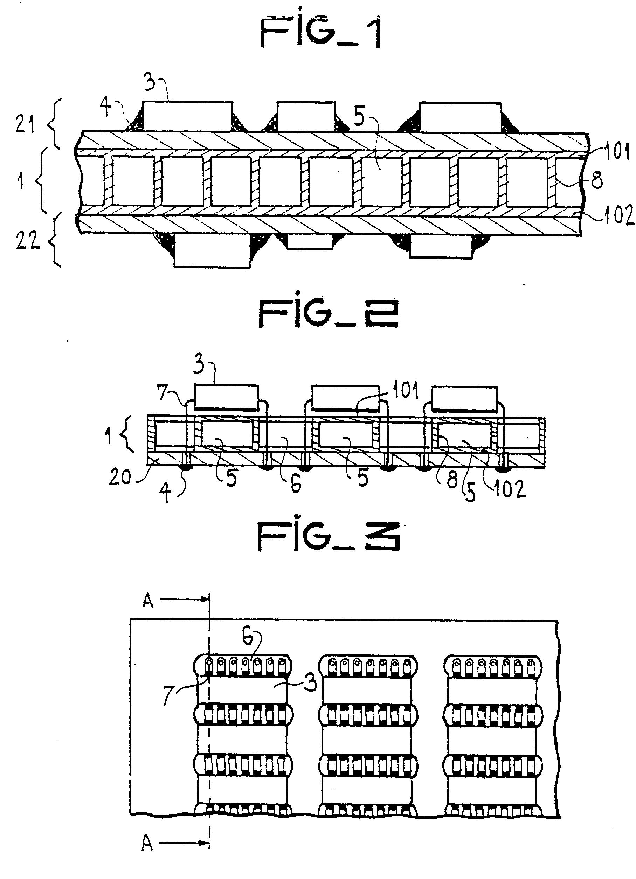

La figure 1 représente une vue latérale en coupe du dispositif selon l'invention lorsque les composants utilisés sont à boîier plat ("flat packaging").

Le dispositif de refroidissement est repéré par la référence 1. Une carte de circuit imprimé 21 équipée sur une face de composants 3 (représentés schématiquement) soudés en 4 est fixée par son autre face sur la surface surface supérieure du dispositif de refroidissement 1.

Une autre carte de circuit imprimé simple face 22 peut être, comme dans le mode de réalisation de la figure 1, fixée sur la surface inférieure du dispositif 1.

Dans ce cas particulièrement simple des composants à boîtier plat, donc ne traversant pas la carte de circuit imprimé, le dispositif 1 est une ossature en cuivre dont les deux faces supérieure 101 et inférieure 102 parallèles sont reliées par des cloisonnements transversaux 8 parallèles et forment des conduits 5 parallélépipédiques adjacents.

Un mode de fabrication d'une telle ossature est représenté par les figures 4a à 4d et décrit ci-après avec référence à cette figure.

Dans le cas de composants, dits "Dual-in-line" ("DIL packaging"), ou de composants traversant la carte de circuit imprimé, le dispositif de refroidissement est légèrement différent et représenté par les figures 2 et 3. En effet il est nécessaire de réaliser des épargnes au niveau des pattes de fixation desdits composants.

La figure 2 est une vue latérale en coupe du dispositif de refroidissement 1 sur la paroi supérieure 101 duquel les composants 3 ont été disposés. Les pattes de fixation 7 des composants 3 traversent l'épaisseur du dispositif de refroidissement 1 à l'interieur des épargnes 6. La figure 3 représente la vue du dessus du dispositif de la figure 2.

Les évidements 5 dans lesquels le fluide de refroidissement circule sont interrompus par des épargnes 6. Ces épargnes sont réalisées au niveau des pattes de fixation 7 des composants 3 dont doit être équipée la carte 20, la carte de circuit imprimée 20 étant rapportée, par collage ou autre moyen connu, sous le dispositif de refroidissement par rapport aux composants, le circuit imprimé étant dirigé vers l'extérieur.

Le composant 3 est par conséquent disposé à cheval sur l'évidement à parois en cuivre dans lequel le fluide de refroidissement (liquide ou gazeux) s'écoule et qui est encadré par les deux épargnes 6 correspondant à ses pattes de fixation 7.

Les pattes de fixation 7 du composant 3 traversent donc le dispositif de refroidissement par les épargnes 6 et la carte 20 par les perforations prévues dans le circuit imprimé et sont soudées en 4 à l'extérieur du dispositif 1, de l'autre côté de la carte 20.

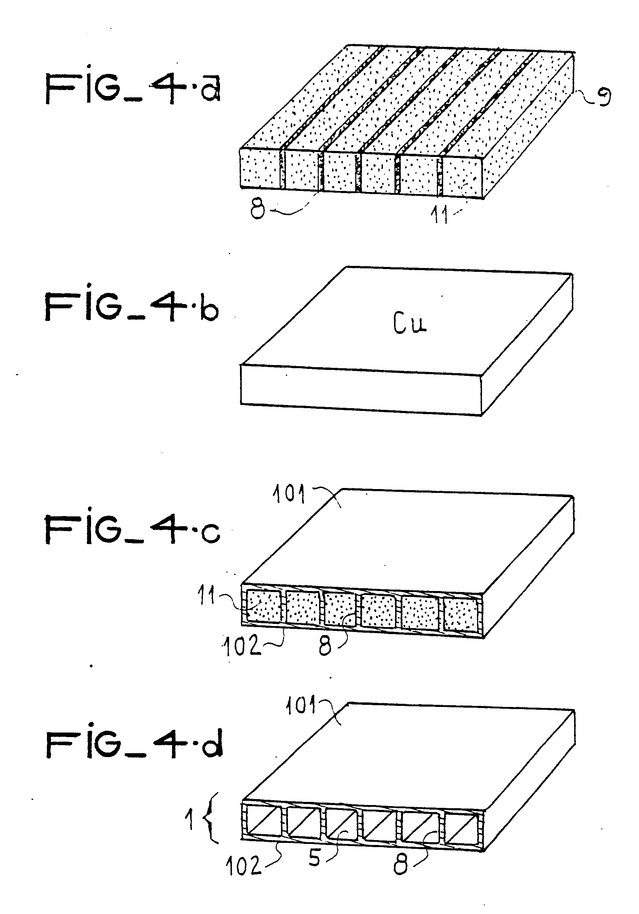

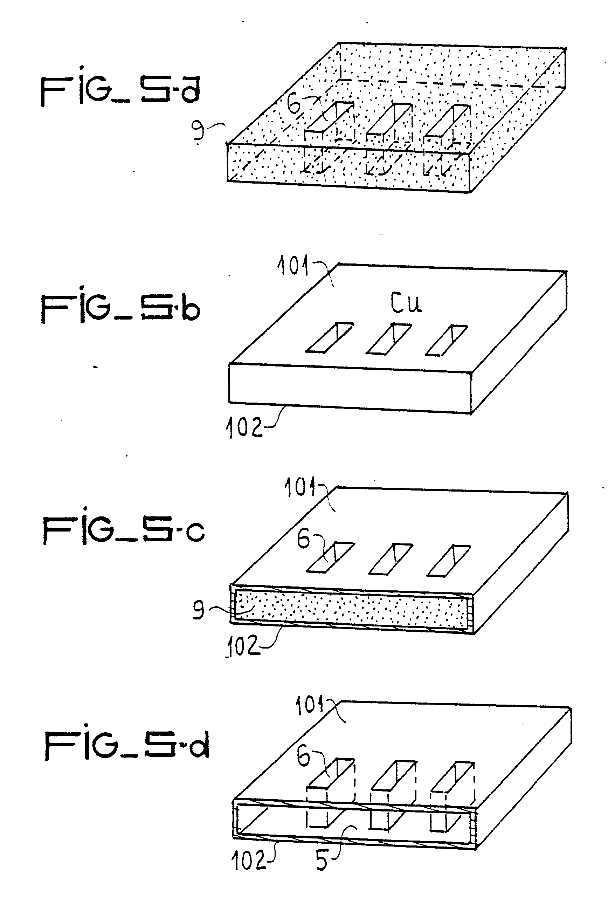

Les différentes phase de la fabrication du dispositif de refroidissement selon l'invention sont représentées schématiquement par les figures 4a à 4d et 5a à 5d correspondant au procédé de fabrication du dispositif respectivement dans le premier cas de composants "à boîtier plat" ("flat Packaging") et dans le deuxième cas de composants "DIL" ou traversant la carte de circuit imprimé.

L'indice "a" des numéros de figure désigne la phase de préparation du noyau, l'indice b la phase d'électroformage, l'indice c la phase d'usinage, l'indice d la phase de dissolution du noyau.

Le noyau 9 est réalisé dans une matière telle que par exemple la cire, ou le métale de Wood ou l'aluminium.

Dans le premier cas (Fig. 4a) le noyau est constitué de barres parallélépipédiques 11 disposées côte à côte longitudinalement et séparées deux à deux par de cloisonnements en cuivre 8.

Dans le deuxième cas, illustré par la figure 5a, le noyau 9 est réalisé d'un seul morceau avec des épargnes 6 correspondant aux pattes de fixation 7 des composants 3, tels qu'ils seront implantés, et traversant totalement l'épaisseur du noyau 9.

La deuxième phase du procédé de fabrication consiste, dans le prmier (fig. 4b) comme dans le deuxième (fig. 5b) cas, à recouvrir la superficie du noyau, à savoir les faces supérieure 101, inférieure 102 et latérales, ainsi que les parois latérales des épargnes 6 lorsqu'il y en a, d'une couche mince de cuivre, par électroformage, procédé connu de l'homme de l'art.

La troisième phase du procédé de fabrication consiste dans le premier (fig. 4c) comme dans le deuxième cas (fig. 5c) à usiner les faces latérales avant et arrière afin d'en enlever la couche de cuivre.

La quatrième phase enfin consiste à faire disparaître le noyau qui est comme mentionné ci-dessus réalisé en une matiére, telle que la cire, dont le point de fusion est très inférieur à celui du cuivre. Le procédé utilisé dans cette quatrième phase pour la dissolution du noyau est connu de l'homme de l'art et ne sera pas décrit ici.

La carte de circuit imprimé est ensuite appliquée, par collage ou tout autre procédé connu, sur le dispositif ainsi obtenu, avec le circuit imprimé visible à l'extérieur.

Les composants 3 sont ensuite implantés suivant le schéma prévu et de la façon indiquée dans le début de la description.

Le fluide de refroidissement, liquide ou gazeux, s'écoule d'une face usinée à l'autre et draine les calories dégagées par les composants 3 grâce à un excellent échange thermique entre le fluide et les composants.

On a ainsi décrit le procédé de fabrication d'un dispositif de refroidissement pour carte de circuit imprimé.

La présente invention est utilisable pricipalement dans le matériel aéroporté.

## Revendications

1. Procédé de fabrication d'un dispositif de refroidissement pour carte de ciruit imprimé, caractérisé en ce qu'il comprend successivement les étapes suivantes:

— moulage d'un noyau parallélépipédique présentant quatre faces latérales et deux faces supérieure et inférieure et réalisé en un matériau dont le point de fusion est très inférieur à celui du cuivre;
— placage d'une couche de cuivre sur toute la superficie du noyau par électroformage;
— usinage de deux faces latérales opposées pour supprimer la couche de cuivre;
— dissolution du noyau laissant ainsi subsister une ossature creuse en cuivre;

la carte de circuit imprimé à refroidir étant ultérieurement fixée sur une face supérieure ou inféieure de l'ossature.

2. Procédé de fabrication selon la revendication 1, caractérisé en ce que dans le noyau sont inclus, avant la phase d'électroformage, une pluralité de cloisonnements en cuivre perpendiculaires aux faces supérieure et inférieure du noyau.

3. Procédé de fabrication selon la revendication 1, caractérisé en ce que, avant la phase d'électroformage, des épargnes sont réalisées à travers le noyau lors de la phase de moulage, orthogonalement aux faces supérieure et inférieure dudit noyau, les parois latérales de épargnes étant également recouvertes de cuivre lors de la phase d'électroformage, les épargnes étant telles qu'elles définisent un passage étanche entre les faces supérieure et inférieure de l'ossature.

4. Utilisation du procédé selo l'une des revendications 1 à 3 à la fabrication d'une carte de circuit imprimé munie du dispositif de refroidissement, caractérisé par le fait qu'elle comporte une étape supplémentaire de fixation de la carte sur l'une des faces supérieure ou inférieure de l'ossature, la face portant le circuit imprimé étant tournée vers l'extérieur.

5. Utilisation selon la revendication 4, caractérisée par le fait qu'elle comporte une étape supplémentaire consistant à disposer un fluide de refroidissement dans l'ossature pour qu'il y circule.

6. Utilisation selon la revendication 4, caractérisée par le fait qu'elle comporte une étape supplémentaire de fixation d'une deuxième carte de circuit imprimé sur l'autre face de l'ossature, la face portant le circuit imprimé étant tournée vers l'extérieur, puis une autre étape supplémentaire d'implantation de composants à boîtier plat sur

les deux cartes.

7. Utilisation selon la revendication 4, caractérisée par le fait qu'elle comporte une étape supplémentaire consistant à disposer des composants munis de pattes de fixation sur l'ossature, sur celle de ses faces qui ne porte la carte, les pattes du composant traversant l'ossature par les épargnes pour être connectées à la carte.

## Patentansprüche

1. Verfahren zur Herstellung einer Kühlvorrichtung für eine gedruckte Schaltungskarte, dadurch gekennzeichnet, daß es die folgenden aufeinanderfolgenden Schritte umfaßt:

— Formen eines quaderförmigen Kerns, der vier Seitenflächen und eine obere Fläche sowie eine untere Fläche aufweist und aus einem Material gebildet ist, dessen Schmelzpunkt sehr viel niedriger als der des Kupfers liegt;  -
— Aufplattieren einer Kupferschicht auf der gesamten Oberfläche des Kerns durch Galvonoformung;
— Bearbeiten von zwei einander gegenüberliegenden Seitenflächen zur Beseitigung der Kuperschicht;  ·
— Auflösen des Kerns, so daß ein hohles Gerippe aus Kupfer stehenbleibt;

wobei die zu kühlende gedruckte Schaltungskarte anschließend auf einer oberen oder unteren Fläche des Gerippes befestigt wird.

2. Herstellungsgerfahren nach Anspruch 1, dadurch gekennzeichnet, daß in dem Kern vor der Phase der Galvanoformung mehrere Trennwände aus Kupfer senkrecht zur oberen und unteren Fläche des Kerns eingeschlossen werden.

3. Herstellungsverfahren nach Anspruch 1, dadurch gekennzeichnet, daß vor der Phase der Galvanoformung Aussparungen durch den Kern hindurch während der Formungsphase senkrecht zur oberen und unteren Fläche des Kerns gebildet werden, wobei die Seitenwände der Aussparungen ebenfalls während der Phase der Galvanoformung mit Kupfer bedeckt werden und wobei die Aussparungen dergestalt sind, daß sie einen dichten Durchgang zwischen der oberen Fläche und der unteren Fläche des Gerippes bilden.

4. Anwendung des Verfahrens nach einem der Ansprüche 1 bis 3 auf die Herstellung einer gedruckten Schaltungskarte, die mit der Kühlvorrichtung ausgestattet ist, dadurch gekennzeichnet, daß sie einen zusätzlichen Schritt der Befestigung der Karte auf der oberen oder unteren Fläche des Gerippes umfaßt, wobei die Fläche, welche die gedruckte Schaltung trägt, nach außen gekehrt ist.

5. Anwendung nach Anspruch 4, dadurch gekennzeichnet, daß sie einen zusätzlichen Schritt umfaßt, der darin besteht, daß ein kühlendes Strömungsmedium in das Gerippe eingebracht wird, um darin zu zirkulieren.

6. Anwendung nach Anspruch 4, dadurch gekennzeichnet, daß sie einen zusätzlichen Schritt der Befestigung einer zweiten gedruckten Schaltungskarte auf der anderen Fläche des Gerippes umfaßt, wobei die Fläche, welche die gedruckte Schaltung trägt, nach außen gewendet ist, und einen weiteren zusätzlichen Schritt des Einsetzens von Bauteilen mit Flachgehäuse auf den beiden Karten Umfaßt.

7. Anwendung nach Anspruch 4, dadurch gekennzeichnet, daß sie einen zusätzlichen Schritt umfaßt, der darin besteht, Bauteile mit Befestigungslaschen auf dem Gerippe anzuordnen, auf derjenigen seier Flächen, welche die Karte nicht trägt, wobei die Laschen des Bauteils das Gerippe durch die Aussparungen hindurch durchqueren, um mit der Karte verbunden zu werden.

## Claims

1. Method of producing a cooling device for a printed circuit board, characterized in that it successively comprises the following steps:

— molding a parallelepipedic core having four lateral faces, an upper face and a lower face and formed of a material the fusion point of which is much lower than that of copper;
— plating a layer of copper on the entire surface of the core by electroforming;
— working two lateral opposed faces to eliminate the copper layer;
— dissolution of the core, thus leaving a hollow carcass of copper;

the printed circuit board to be cooled being subsequently fixed on an upper or lower face of the carcass.

2. Production method according to claim 1, characterized in that, prior to the electroforming phase, a plurality of partitions of copper are included perpendicularly to the upper and lower faces of the core.

3. Production method according to claim 1, characterized in that, prior to the electroforming phase, recesses are made through the core during the molding phase, perpendicularly to the upper and lower faces of said core, the lateral walls of the recesses being likewise covered with copper during the electroforming phase, the recesses being such that they define a tight passage between the upper and lower faces of the carcass.

4. Use of the method according to any of claims 1 to 3 for the production of a printed circuit board provided with the cooling device, characterized by the fact that it comprises an additional step of fixing the board on one of the upper and lower faces of the carcass, the face carrying the printed circuit being directed outwardly.

5. Use according to claim 4, characterized by the fact that it comprises an additional step consisting in the introduction of a cooling fluid unto the carcass for circulation therein.

6. Use according to claim 4, characterized by the fact that it comprises an additional step of fixing a second printed circuit board on the other face of the carcass, the face carrying the printed

7 | **0 083 538** | 8

circuit being directed outwardly, and then a further additional step of implanting flat package type components on the two boards.

7. Use according to claim 4, characterized by the fact that it comprises an additional step consisting in mounting components provided with fixing legs on the carcass, on that of its faces which does not carry the board, the legs of the components crossing the carcass through the recesses to be connected to the board.

0 083 538

FIG_1

FIG_2

FIG_3

1

FIG_4·a

FIG_4·b

Cu

FIG_4·c

FIG_4·d

FIG_5·a

6
9

FIG_5·b

101
Cu
102

FIG_5·c

101
6
9
102

FIG_5·d

101
6
102    5